(19) Europäisches Patentamt
European Patent Office
Office européen des brevets

(11) Veröffentlichungsnummer: **0 313 007 A2**

(12) # EUROPÄISCHE PATENTANMELDUNG

(21) Anmeldenummer: **88117371.0**

(51) Int. Cl.4: **G03C 1/68**

(22) Anmeldetag: **19.10.88**

(30) Priorität: **23.10.87 US 112795**

(43) Veröffentlichungstag der Anmeldung:
**26.04.89 Patentblatt 89/17**

(84) Benannte Vertragsstaaten:
**AT BE DE FR GB IT NL**

(71) Anmelder: **HOECHST CELANESE CORPORATION**
**Route 202-206 North**
**Somerville, N.J. 08876(US)**

(72) Erfinder: **Wilczak, Wojciech A.**
**30 Country Club Lane**
**Scotch Plains New Jersey 07076(US)**
Erfinder: **Geiger, Margaret W.**
**11 Murray Drive**
**Neshanic Station New Jersey 08853(US)**

(74) Vertreter: **Euler, Kurt Emil, Dr. et al**
**HOECHST AG - Werk KALLE Patentabteilung**
**Postfach 3540 Rheingaustrasse 190**
**D-6200 Wiesbaden(DE)**

(54) **Durch sichtbares Licht polymerisierbares Gemisch.**

(57) Es wird ein photopolymerisierbares Gemisch sowie ein daraus hergestelltes Aufzeichnungsmaterial beschrieben, das eine ethylenisch ungesättigte polymerisierbare Verbindung, insbesondere einen Acryl- oder Methacrylsäureester, ggf. ein polymeres Bindemittel und eine Kombination aus einer basischen Acridinverbindung und einem durch Halogenmethylgruppen substituiertem Triazin oder Chinazolinon enthält. Das Gemisch hat eine besonders hohe Lichtempfindlichkeit im sichtbaren Spektralbereich und ist zur Belichtung durch Laser oder durch Projektion geeignet.

EP 0 313 007 A2

Xerox Copy Centre

## Durch sichtbares Licht polymerisierbares Gemisch

Die vorliegende Erfindung betrifft gegenüber sichtbarem Licht empfindliche Photoinitiatoren, die für Bilderzeugungsverfahren mittels Laserstrahlen geeignet sind. Insbesondere betrifft sie photopolymerisierbare Gemische mit erhöhter effektiver Lichtempfindlichkeit, die für die Herstellung lichtempfindlicher Materialien, z. B von Flachdruckplatten für Projektionsbelichtung, geeignet sind.

Zahlreiche Substanzen haben sich bereits als Photopolymerisationsinitiatoren bewährt. Dazu gehören Benzoinverbindungen, wie Benzoin, Benzoinmethylether oder -ethylether, Carbonylverbindungen wie Benzil, Benzophenon, Acetophenon oder Michlers Keton, Azoverbindungen, wie Azobisisobutyronitril, sowie Verbindungen aus der Klasse der Acridine, Chinoxaline oder Phenazine. Diese Photoinitiatoren sind zwar gut geeignet, doch besteht in vielen Fällen der Wunsch nach gegenüber sichtbarem Licht empfindlichen Materialien, deren effektive Lichtempfindlichkeit über den Werten liegt, die mit den bekannten Photoinitiatoren erzielbar sind. Eine höhere effektive Lichtempfindlichkeit wird beispielsweise für lichtempfindliche Materialien angestrebt, die mit Lasern geringer Intensität oder durch Projektion belichtet werden sollen. Bei Druckplatten, die nicht durch Projektion belichtet werden, erfolgt die Belichtung durch eine Maske, die in einem Vakuum belichtungsrahmen in Kontakt mit der lichtempfindlichen Schicht gebracht wird, mittels einer UV-Lichtquelle hoher Intensität. Bei der Projektionsbelichtung ist die Belichtungsmaske im Strahlengang des Lichts zwischen der Lichtquelle und dem Objektiv einer Kamera angeordnet, und das Bild wird durch das Objektiv auf eine Druckplatte projiziert, die auf einer Bühne liegt. Hierdurch wird die Belichtungsenergie erheblich herabgesetzt, und deshalb sollte die Lichtempfindlichkeit entsprechend größer werden. Die vorstehend beschriebenen Typen von Photoinitiatoren allein sind dafür jedoch nicht empfindlich genug. Auch die zur Belichtung eingesetzten Laser verfügen nur über geringe Intensität.

Aufgabe der Erfindung war es, ein photopolymerisierbares Gemisch vorzuschlagen, das bei Belichtung mit Licht einer Wellenlänge von 400-500 nm rasch zu polymerisieren vermag und zur Belichtung mit einem Argonlaser geeignet ist.

Erfindungsgemäß wird ein photopolymerisierbares Gemisch vorgeschlagen, das als wesentliche Bestandteile eine photopolymerisierbare Verbindung mit mindestens einer, bevorzugt mindestens zwei endständigen ethylenisch ungesättigten Gruppen und eine Photoinitiatorkombination enthält.

Das erfindungsgemäße Gemisch ist dadurch gekennzeichnet, daß die Kombination aus einer basischen Acridinverbindung und einem durch Halogenmethylgruppen substituierten Triazin oder Chinazolinon besteht.

Außerdem betrifft die Erfindung ein photopolymerisierbares Aufzeichnungsmaterial mit einem Schichtträger und einer darauf aufgebrachten photopolymerisierbaren Schicht, das dadurch gekennzeichnet ist, daß die Schicht aus dem vorstehend bezeichneten Gemisch besteht.

Acridinfarbstoffe sind an sich bekannt und beispielsweise in der US-A 3,751,259 ausführlich beschrieben.

Für den Einsatz in dem erfindungsgemäßen Gemisch müssen diese Acridinverbindungen, die in Salzform vorliegen, basisch gemacht werden. Dies geschieht beispielsweise durch Umsetzen des Acridiniumsalzes mit einer Base, z. B. Natriumhydroxid, in Wasser. Das Fällungsprodukt wird anschließend gewaschen und getrocknet. Danach kann es erfindungsgemäß eingesetzt werden. Unter den Acridinverbindungen werden als Ausgangsmaterialien Acridinorange (3,6-Bis-dimethylamino-acridiniumchlorid) und Acridingelb (3,6-Diamino-2,7-dimethyl-acridiniumchlorid) besonders bevorzugt.

Als allgemeine Formel für die basischen Acridine gilt:

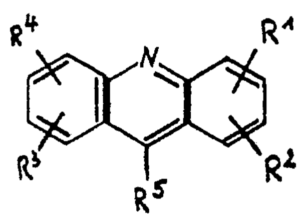

wobei

$R^1$ $NR_2$ oder H,

$R^2$ und $R^3$ Halogen oder R,

$R^4$ $NR_2$ oder H,

$R^5$ H, $CH_3$, Phenyl oder durch eine $NR_2$-, oder COOH-Gruppe substituiertes Phenyl und

R H oder eine Alkylgruppe mit 1-3 Kohlenstoffatomen

bedeuten.

Als zweite Komponente enthält das Initiatorgemisch eine durch Mono-, Di- oder Trihalogenmethylgruppen substituierte Triazin- oder Chinazolinonverbindung. Derartige Triazinverbindungen sind beispielsweise
2-Methyl-4,6-bis(trichlormethyl)-1,3,5-triazin,
2,4,6-Tris(trichlormethyl)-1,3,5-triazin,
2-Methyl-4,6-bis(tribrommethyl)-1,3,5-triazin,
2,4,6-Tris(tribrommethyl)-1,3,5-triazin,
2,4,6-Tris(dichlormethyl)-1,3,5-triazin,
2,4,6-Tris(dibrommethyl)-1,3,5-triazin,
2,4,6-Tris(brommethyl)-1,3,5-triazin,
2,4,6-Tris(chlormethyl)-1,3,5-triazin,
2-Phenyl-4,6-bis(trichlormethyl)-1,3,5-triazin,
2-(p-Methoxyphenyl)-4,6-bis(tribrommethyl)-1,3,5-triazin,
2-Phenyl-4,6-bis(tribrommethyl)-1,3,5-triazin,
2-(p-Chlorphenyl)-4,6-bis(trichlormethyl)-1,3,5-triazin
und 2-(p-Tolyl)-4,6-bis(trichlormethyl)-1,3,5-triazin.
Weitere geeignete Triazinverbindungen sind in den US-A 3,729,313, US-A 4,239,850, US-A 4,481,276 und US-A 4,595,793 aufgezählt.

Als Chinazolinonverbindungen sind erfindungsgemäß 2-Trichlormethyl-4(3H)-chinazolinon und 2-Tribrommethyl-4(3H)-chinazolinon geeignet. Verbindungen dieses Typs sind ausführlich in der DE-A 33 39 228 beschrieben.

Das Gewichtsverhältnis von Acridinverbindung zu Triazin-, bzw. Chinazolinonverbindung liegt im Bereich von 1:20 bis 4:1, bevorzugt von 1:15 bis 3:1, insbesondere von 1:10 bis 2:1. Gegebenenfalls kann Michlers Keton in einer Menge von 5 bis 40 %, bevorzugt 10 bis 20 %, bezogen auf das Gewicht des Initiatorgemisches, zugesetzt werden.

Das erfindungsgemäße photopolymerisierbare Gemisch enthält eine polymerisierbare Verbindung mit mindestens einer, vorzugsweise mindestens zwei Doppelbindungen und bevorzugt außerdem ein polymeres harzartiges Bindemittel.

Die polymerisierbare Verbindung ist eine additionspolymerisierbare, nicht gasförmige (Siedetemperatur bei Normaldruck über 100 °C), ethylenisch ungesättigte Verbindung mit bevorzugt mindestens zwei endständigen ethylenischen Gruppen, die befähigt ist, durch eine radikalisch initiierte Additionspolymerisation ein hochmolekulares Polymeres zu bilden. Geeignete polymerisierbare Verbindungen sind beispielsweise Acryl-oder Methacrylsäureester wie
Polybutandioldiacrylat, Tetraethylenglykoldimethacrylat, Ethylenglykoldimethacrylat, Trimethylolpropantrimethacrylat, Trimethylolpropantriacrylat, Polyethylenglykol-(200)-diacrylat, Diethylenglykoldimethacrylat, Pentaerythrittetraacrylat, Dicyclopentenylacrylat, Dicyclopentenylmethacrylat, 1,4-Butandioldiacrylat, 1,6-Hexandioldimethacrylat, Dipentaerythritpentaacrylat, ethoxyliertes Bisphenol-A-dimethacrylat und Tripropylenglykoldiacrylat.

Als Bindemittel sind erfindungsgemäß geeignet:
Styrol-Maleinsäurepartialester- oder Styrol-Maleinsäureanhydrid-Copolymere, deren Monomerenverhältnis bevorzugt im Bereich von 70:30 bis 95:5 liegt; Copolymere oder Terpolymere mit Einheiten von Methylmethacrylat und Methacrylsäure, z. B. Methylmethacrylat-Methacrylsäure-Copolymere in einem Monomerenverhältnis von 70:30 bis 95:5, Methylmethacrylat-Ethylacrylat-Methacrylsäure-Copolymere in einem Monomerenverhältnis von 50:30:20 bis 90:5:5; und Methylmethacrylat-Butylacrylat-Methacrylsäure-Copolymere in einem Monomerenverhältnis von 50:30:20 bis 90:5:5. Außerdem sind Bindemittel geeignet, die keine saure Komponente enthalten, deren Löslichkeitseigenschaften jedoch eine einwandfreie Entwicklung in wäßrig-alkalischen Entwicklerlösungen gewährleisten. Dazu gehören beispielsweise Vinylpyrrolidonpolymere des Typs K-60 und K-99 (G.A.F), Cellulose ether, wie Hydroxypropylcellulose, Methylcellulose und Ethylhydroxyethylcellulose. Ferner können Polyvinylacetale, wie Polyvinylformal und Polyvinylbutyral, sowie Polyvinylalkohole verwendet werden. Auch Oligomere wie Uvithane 788 (Morton Thiokol) und Macromer 13KRC (Sartomer) sind geeignet.

Bevorzugt wird als Bindemittel ein Polymeres aus Einheiten der allgemeinen Typen A, B und C eingesetzt, wobei A in einem Mengenanteil von 5 bis 20 Gew.-% vorliegt und eine Vinylacetateinheit ist, B in einem Mengenanteil von 4 bis 30 Gew.-% vorliegt und eine Vinylalkoholeinheit ist, und C in einem Mengenanteil von 50 bis 91 Gew.-% vorliegt und eine Vinylacetaleinheit einer der Formeln I, II und III

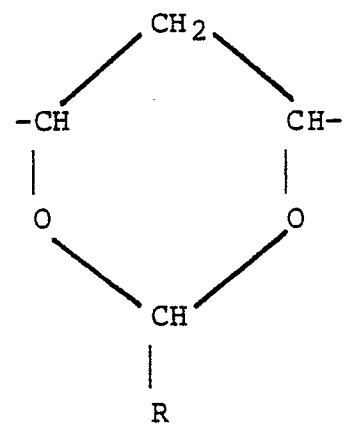 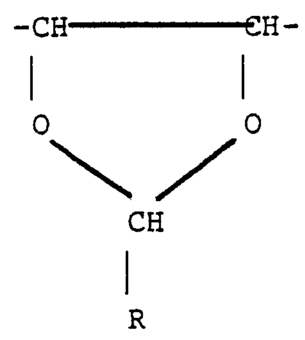 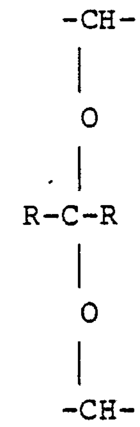

(I) (II) (III)

ist, in denen

R ein Wasserstoffatom oder eine niedere Alkylgruppe ist,

und wobei die Einheiten I in einem Anteil von 75 bis 85 Gew.-%, die Einheiten II in einem Anteil von 3 bis 5 Gew.-% und die Einheiten III in einem Anteil von 10 bis 22 Gew.-%, jeweils bezogen auf die Gesamtzahl der Einheiten C vorliegen. Derartige Bindemittel sind ausführlich in der EP-A 216,083 beschrieben

Zur Einfärbung der Bildstellen kann das photopolymerisierbare Gemisch ferner Farbstoffe oder Pigmente enthalten. Sie werden in einer geringen Menge einer geeigneten Lösung, z. B. einer Lösung eines Copolymeren von Methylmethacrylat und Methacrylsäure (85:15) in Methylethylketon dispergiert.

Zu den geeigneten Farbstoffen und Pigmenten zählen Benzidingelb G (C.I. 21090), Benzidingelb GR (C.I. 21100), Permanentgelb DHG, Brillantcarmin (C.I. 15850), Rhodamin 6G (C.I. 45160), Rhodamin B (C.I. 45170), nicht-kristallines Phthalocyaninblau (C.I. 74160), Phthalocyaningrün (C.I. 74260), Ruß, Fettgelb 5G, Fettgelb 3G, Fettrot G, Fettrot HRR, Fettrot 5B, Fettschwarz HB, Zaponechtschwarz RE, Zaponechtschwarz G, Zaponechtblau HFL, Zaponechtrot BB, Zaponechtrot GE, Zaponechtgelb G, und Chinacridonrot (C.I. 46500).

Im Rahmen der Erfindung wird die Bindemittelkomponente in ausreichender Menge eingesetzt, um ein homogenes Gemisch der einzelnen Bestandteile und eine gleichmäßige Schichtdicke auf dem jeweiligen Träger zu erzielen. Im allgemeinen beträgt der Bindemittelanteil 18 bis 40 Gew.-%, bevorzugt 20 bis 38 Gew.-% und insbesondere 22 bis 33 Gew.-%, jeweils bezogen auf den Feststoffgehalt des Gemischs.

Das Photoinitiatorengemisch ist in dem erfindungsgemäßen photopolymerisierbaren Gemisch in solcher Menge vorhanden, daß bei der bildmäßigen Belichtung die radikalische Polymerisation der ungesättigten Komponente eingeleitet wird. Sein Anteil am Gesamtfeststoffgehalt beträgt 5 bis 25 Gew.-%, bevorzugt 8 bis 22 Gew.-% und insbesondere 10 bis 20 Gew.-%.

Der Farbstoff bzw. das Pigment ist in dem erfindungsgemäßen photopolymerisierbaren Gemisch in solcher Menge vorhanden, daß eine gleichmäßige Färbung erzielt wird. Sein Anteil am Gesamtfeststoffgehalt beträgt 1 bis 20 Gew.-%, vorzugsweise 3 bis 18 Gew.-%, und insbesondere 5 bis 15 Gew.-%.

Die polymerisierbare Verbindung ist in dem erfindungsgemäßen photopolymerisierbaren Gemisch in solcher Menge vorhanden, daß bei der bildmäßigen Belichtung der auf einen Träger aufgebrachten polymerisierbaren Schicht eine bildmäßige Differenzierung stattfindet. Ihr Anteil am Gesamtfeststoffgehalt beträgt 20 bis 60 Gew.-%, bevorzugt 22 bis 58 Gew.-% und insbesondere 25 bis 55 Gew.-%.

Außerdem kann das erfindungsgemäße photopolymerisierbare Gemisch als weitere Bestandteile stabilisierende Säuren, Belichtungsindikatoren, Weichmacher und Sensibilisatoren enthalten.

Als stabilisierende Säuren sind z. B. Phosphor-, Citronen-, Benzoe-, m-Nitrobenzoe-, p-(p-Anilinophenylazo)-benzolsulfon-, 4,4′-Dinitrostilben-2,2-disulfon-, Itacon-, Wein- und p-Toluolsulfonsäure, sowie Mischungen aus diesen Säuren geeignet. Bevorzugt wird Phosphorsäure verwendet. Der Anteil der gegebenenfalls zugesetzten stabilisierenden Säure am photopolymerisierbaren Gemisch beträgt vorzugsweise 0,3 bis 2,0 %, insbesondere 0,5 bis 1,5 %.

Zu den erfindungsgemäß geeigneten Belichtungsindikatoren zählen 4-Phenylazodiphenylamin, Eosin, Azobenzol, Calcozin, Fuchsinfarbstoffe, Kristallviolett und Methylenblau, wobei 4-Phenylazodiphenylamin

bevorzugt eingesetzt wird. Der Anteil des gegebenenfalls zugesetzten Belichtungsindikators am erfindungsgemäßen Gemisch beträgt 0,001 bis 0,035 Gew.-%, bevorzugt 0,002 bis 0,030 Gew.-%, und insbesondere 0,005 bis 0,020 Gew.-%.

Als erfindungsgemäß geeigneter Sensibilisator sollte eine aminhaltige Verbindung gewählt werden, die mit dem radikalischen Photoinitiator in der Weise synergistisch zusammenwirkt, daß die effektive Halbwertzeit des Photoinitiators, die üblicherweise etwa $10^{-9}$ bis $10^{-15}$ Sekunden beträgt, verlängert wird. Als Beispiele für geeignete Sensibilisatoren seien 2-(n-Butoxy)-ethyl-4-dimethylaminobenzoat, 2-(Dimethylamino)-ethyl-aminobenzoat und acrylierte Amine genannt. Der Anteil des gegebenenfalls zugesetzten Belichtungsbeschleunigers am erfindungsgemäßen Gemisch beträgt bevorzugt 1,0 bis 4,0 Gew.-%.

Im erfindungsgemäßen Gemisch kann gegebenenfalls auch ein Weichmacher enthalten sein, um ein Verspröden der Beschichtung zu verhindern und die Schicht nötigenfalls biegsam zu halten. Geeignete Weichmacher sind Dibutylphthalat, Triarylphosphat und deren substituierte Analoge, sowie bevorzugt Dioctylphthalat. Ihr Anteil am erfindungsgemäßen Gemisch beträgt vorzugsweise 0,5 bis 1,25 Gew.-%.

Zur Herstellung einer Beschichtungslösung kann das erfindungsgemäße Gemisch in einem Lösemittel oder Lösemittelgemisch gelöst werden. Hierfür geeignete Lösemittel sind zum Beispiel Wasser, Tetrahydrofuran, Butyrolacton, Glykolether, wie Propylenglykolmonomethylether und Ethylenglykolmonomethylether, Alkohole, wie Ethylalkohol und n-Propanol, und Ketone, wie Methylethylketon, sowie Mischungen aus diesen Lösemitteln. Bevorzugt wird eine Mischung aus Tetrahydrofuran, Propylenglykolmonomethylether und Butyrolacton.

Zu den Trägermaterialien, die für die Beschichtung mit dem erfindungsgemäßen Gemisch, z. B. zur Herstellung von Farbprüffolien, Siebdruckschablonen, Photoresists oder Flachdruckplatten geeignet sind, zählen transparente Folien, z. B. aus Polyester; Aluminium und seine Legierungen, andere Metalle, Gewebe, Silicium und ähnliche bekannte Stoffe, die für die Halbleiterherstellung geeignet sind, z. B. Galliumarsenid. Aluminium wird bevorzugt als Trägermaterial eingesetzt. Der Träger wird gegebenenfalls zunächst mit Hilfe eines üblichen Verfahrens aufgerauht und/oder geätzt und/oder anodisiert und kann außerdem zusätzlich z. B. mit Polyvinylphosphonsäure, Natriumsilikat oder anderen hydrophilierend wirkenden Mitteln behandelt werden.

Zur Herstellung von Reproduktionsmaterialien, z. B. Flachdruckplatten, wird ein Schichtträger auf Basis von Aluminium zunächst vorzugsweise in bekannter Weise, z. B durch Drahtbürsten, Naßschleifen oder auf chemischem oder elektrochemischem Weg, z. B. in einem Salzsäureelektrolyten, aufgerauht. Die aufgerauhte Platte wird danach vorzugsweise auf bekannte Weise anodisch oxydiert, z. B. in Schwefel- oder Phosphorsäure. Die aufgerauhte und gegebenenfalls anodisch oxydierte Oberfläche wird anschließend bevorzugt noch einer hydrophilierenden Nachbehandlung unterworfen, z. B. mit Polyvinylphosphonsäure, Natriumsilikat oder dergleichen. Die solchermaßen vorbereitete Platte wird mit dem erfindungsgemäßen Gemisch beschichtet und anschließend getrocknet. Das Schichtgewicht beträgt vorzugsweise etwa 0,6 bis 2,5 g/m², insbesondere etwa 0,8 bis 2,0 g/m², und ganz besonders bevorzugt etwa 1,2 bis 1,5 g/m².

Im Anschluß daran wird die lichtempfindliche Schicht mittels aktinischer Strahlung bestrahlt, z. B. mit sichtbarem oder ultraviolettem Licht oder mit Röntgen-oder Korpuskularstrahlung, wie Elektronen- oder Ionen strahlen. Bevorzugt erfolgt die Belichtung in bekannter Weise, z. B. mit UV-Strahlung durch eine Photomaske in einem Vakuumrahmen. Die Belichtung kann durch eine herkömmliche Negativvorlage erfolgen. Bevorzugt wird im Schicht-auf-Schicht-Kontakt belichtet. Quecksilberdampflampen werden gegenüber Metallhalogenidlampen bevorzugt. Zur Vermeidung von Lichtstreueffekten können Filter eingesetzt werden. Die erfindungsgemäßen Materialien sind hervorragend für die Projektionsbelichtung geeignet.

Das Reproduktionsmaterial wird bevorzugt durch eine negative Testvorlage mittels aktinischer Strahlung so belichtet, daß auf einem 21-stufigen Staufferkeil die Stufe 6 voll gedeckt ist. Die belichtete Platte wird mit einem geeigneten wäßrigen Entwicklergemisch entwikkelt, z. B. mit einem Entwickler, der in wäßriger Lösung eine oder mehrere der folgenden Verbindungen enthält:

a) ein Natrium-, Kalium- oder Lithiumsalz von Monooctyl-, -decyl- oder -dodecylsulfat,

b) ein Natrium-, Lithium-, Kalium- oder Ammoniummetasilikat,

c) ein Lithium-, Kalium-, Natrium- oder Ammoniumborat,

d) eine aliphatische Dicarbonsäure mit 2 bis 6 C-Atomen oder ihr Natrium-, Kalium- oder Ammoniumsalz und

e) Mono-, Di- oder Trinatrium- oder -kaliumphosphat.

Auch Wasser oder wäßrige Lösungen von Benzoesäure oder Natrium-, Lithium- oder Kaliumbenzoat oder deren Hydroxyderivaten, sowie die in der US-A 4,436,807 beschriebenen Entwickler sind erfindungsgemäß geeignet. Ferner können in dem Entwickler auch organische Lösemittel enthalten sein, doch werden Entwickler ohne organische Lösemittel bevorzugt.

Im folgenden wird die Erfindung anhand von Beispielen näher erläutert, in denen Mengenverhältnisse und Prozente in Gewichtseinheiten zu verstehen sind, wenn nichts anderes angegeben ist.

Beispiel 1

In einer Schleifmittelsuspension aufgerauhtes und anodisch oxydiertes Aluminium wird mit einer Drahtrakel Nr. 24 mit den folgenden Lösungen beschichtet:

| | A (Gew.-%) | B (Gew.-%) |
|---|---|---|
| Propylenglykolmonomethylether | 56 | 56 |
| Methylethylketon | 23,76 | 23,76 |
| Butyrolacton | 12,96 | 12,96 |
| Scripset 540 (Styrol-Monosiobutylmaleinat-Copolymeres, Säurezahl 400) | 1,72 | 1,72 |
| Polyvinylpropional [1] | 0,26 | 0,26 |
| Pentaerythrittriacrylat | 3,83 | 3,83 |
| Michlers Keton | 0,19 | 0,19 |
| Acridinorangebase | 0,19 | - |
| Acridingelbbase | - | 0,19 |
| 2-Trichlormethyl-4(3H)-chinazolinon | 1,09 | 1,09 |

[1] enthaltend 13,6 % Vinylacetat-, 9,8 % Vinylalkohol- und 76,6 % Vinylpropionaleinheiten, wobei die Vinylpropionaleinheiten zu 80 % aus sechsgliedrigen cyclischen Acetaleinheiten, zu 4 % aus fünfgli drigen cyclischen Acetaleinheiten und zu 16 % aus intermolekularen Acetaleinheiten bestehen.

Die beschichteten Platten werden bei 66 °C in Trockenschrank getrocknet und anschließend mit Hilfe einer Drahtrakel mit einer 3%igen wäßrigen Lösung von Poly vinylalkohol (Gelvatol 20/30) beschichtet und getrocknet.

Zur Belichtung wird eine 2 kW Lampe bei geringerer Leistung benutzt. Die Belichtung erfolgt durch einen Staufferkeil, wobei einmal ohne Filter und einmal durch eine Dylux-Filterfolie (Hersteller Du Pont), die Wellenlänge unter 400 nm absorbiert, belichtet wird. Die belichteten Platten werden mit einer Entwicklerlösung aus

| | |
|---|---|
| 10 g | anionischem Netzmittel (Tergitol 04), |
| 2,5 g | Trinatriumphosphat x $12H_2O$, |
| 0,3 g | Mononatriumdihydrogenphosphat und |
| 100 g | entionisiertem Wasser, |

die einen pH-Wert von 11,4 besitzt, entwickelt.

Die Anzahl der voll gedeckten (V) und der teilweise gedeckten (T) Stufen, die auf den mit Beschichtungslösungen A und B versehenen Platten jeweils erhalten werden, ist in Tabelle 1 angegeben.

Tabelle 1

| | Belichtungs zeit (s) | Ohne Filter | | Belichtungszeit (s) | Mit Filter | |
|---|---|---|---|---|---|---|
| | | V | T | | V | T |
| A | 5 | - | 8 | 40 | - | 6 |
| B | 5 | 10 | 11 | 40 | 7 | 8 |

Platten des gleichen Typs werden anschließend mittels einer 100 W Xenonlampe belichtet, der jeweils ein Schottfilter GG-455, bzw. GG-475 vorgeschaltet ist, so daß Lichtwellen unter 455 m bzw. unter 475 nm

eliminiert werden. Die Ergebnisse sind in Tabelle 2 zusammengefaßt.

Tabelle 2

| | GG-455 Belichtungszeit (s) | T | GG-475 Belichtungszeit (s) | T |
|---|---|---|---|---|
| A | 20 | 9 | 10 | 6 |
| B | 10 | 7 | 10 | 5 |

Beispiel 2

In einer Schleifmittelsuspension aufgerauhtes und anodisch oxydiertes Aluminium wird wie im Beipiel 1 beschrieben mit den folgenden Lösungen beschichtet:

| | A Gew.-%) | B Gew.-%) |
|---|---|---|
| Propylenglykolmonomethylether | 56,000 | 56,073 |
| Methylethylketon | 23,738 | 23,780 |
| Butyrolacton | 13,072 | 13,090 |
| Scripset 540 | 1,743 | 1,745 |
| Polyvinylpropional wie in Beispiel 1 | 0,261 | 0,261 |
| Ethoxyliertes Trimethylolpropantriacrylat | 3,813 | 3,818 |
| Michlers Keton | 0,142 | - |
| Acridingelbbase | 0,142 | 0,142 |
| Tris(trichlormethyl)-s-triazin | 1,089 | 1,091 |

Die Platten werden wie in Beispiel 1 getrocknet und mit einer Beschichtung aus Polyvinalalkohol versehen.

Belichtet wird mit einer 2 kW Lampe bei geringerer Leistung, und zwar jeweils mit und ohne Dylux-Filterfolie. Die mit dem Entwickler aus Beispiel 1 entwickelten Platten werden mit einer handelsüblichen Konservierungslösung behandelt und eingefärbt. Die Ergebnisse sind in Tabelle 3 zusammengefaßt.

Tabelle 3

| | Belichtungszeit (s) ohne Filter | V | Belichtungszeit (s) mit Filter | V |
|---|---|---|---|---|
| A | 2 | 7 | 15 | 14 |
| B | 2 | 4 | 15 | 10 |

Beipiel 3

Eine haftvermittelnd vorhandelte Polyesterträgerfolie wird mit einer Drahtrakel Nr. 12 mit der folgenden lichtempfindlichen Lösung beschichtet:

49,514 Gew.-% 2-Methoxy-ethanol,
21,011 Gew.-% Methylethylketon,
11,449 Gew.-% Butyrolacton,
1,541 Gew.-% Scripset 540,
0,385 Gew.-% Polyvinylpropional wie in Beispiel 1,
0,164 Gew.-% Michlers Keton,

0,048 Gew.-% Acridingelbbase,
3,370 Gew.-% Pentaerythrittiacrylat,
0,963 Gew.-% Tris(trichlormethyl)triazin und
11,555 Gew.-% blaue Pigmentdispersion (1)
(1) 44 % Propylenglykolmonomethylether,
44 % Butyrolacton,
5,5 % Polyvinylpropional wie in Beispiel 1
6,5 % Hostapermblau B2G

Die beschichtete Folie wird wie in Beispiel 1 beschrieben getrocknet und mit einer Lösung von Polyvinylalkohol beschichtet. Anschließend wird mit einer im Abstand von 15 cm angeordneten 100 W Xenonlampe 5 Sekunden durch ein 475 nm-Filter belichtet und mit dem Entwickler von Beispiel 1 entwickelt. Auf dem Staufferkeil ist die Stufe 6 klar.

<u>Beispiel 4</u>

Zum Vergleich wird eine Beschichtungslösung der folgenden Zusammensetzung hergestellt:

| | |
|---|---|
| 51,42 g | 2-Methoxy-ethanol, |
| 21,82 g | Methylethylketon, |
| 1,57 g | Scripset 540, |
| 0,25 g | Polyvinylpropional aus Beispiel 1, |
| 1,00 g | Trichlormethylchinazolinon, |
| 0,17 g | Acridinorangehydrochlorid, |
| 3,50 g | Pentaerythrittriacrylat und |
| 12,00 g | der blauen Pigmentdispersion von Beispiel 3. |

Das Gemisch wird auf eine Polyesterfolie aufgetragen, getrocknet und mit einer Schicht aus Polyvinylalkohol versehen. Die Belichtung erfolgt mittels einer 100 W Xenonlampe durch ein GG 455-Filter der Firma Schott während einer Minute. Nach der Entwicklung mit dem Entwickler von Beispiel 1 ist kein Bild erkennbar, was bedeutet, daß bei Verwendung der Acridinverbindung in ihrer Salzform, d. h. der nicht basisch gemachten Acridinverbindung, kein Bild erzeugt werden kann.

<u>Beispiel 5</u>

Beispiel 4 wird wiederholt, mit dem Unterschied, daß die Acridinverbindung in basischer Form eingesetzt wird. Dazu wird das Acridinorangehydrochlorid mit einem Überschuß an 10%iger wäßriger Kalilauge behandelt. Das Fällungsprodukt wird in Wasser gewaschen und getrocknet. Durch Belichten und Weiterbehandeln einer mit dieser Verbindung analog zu Bespiel 4 hergestellten Platte werden auf dem Staufferkeil 7 freie Stufen erhalten.

## Ansprüche

1. Photopolymerisierbares Gemisch, das als wesentliche Bestandteile eine polymerisierbare Verbindung mit mindestens einer endständigen ethylenisch ungesättigten Gruppe und eine Photoinitiatorkombination enthält, dadurch gekennzeichnet, daß die Kombination aus einer basischen Acridinverbindung und einem durch Halogenmethylgruppen substituierten Triazin oder Chinazolinon besteht.

2. Photopolymerisierbares Gemisch nach Anspruch 1, dadurch gekennzeichnet, daß die Acridinverbindung und die Triazin- oder Chinazolinonverbindung im Gewichtsverhältnis 1:20 bis 4:1 verliegen.

3. Photopolymerisierbares Gemisch nach Anspruch 1, dadurch gekennzeichnet, daß die polymerisierbare Verbindung ein Acryl- oder Methacrylsäureester ist.

4. Photopolymerisierbares Gemisch nach Anspruch 1, dadurch gekennzeichnet, daß es zusätzlich ein polymeres Bindemittel enthält.

5. Photopolymerisierbares Gemisch nach Anspruch 4, dadurch gekennzeichnet, daß das Bindemittel ein Polyvinylacetal, Polyvinylpyrrolidon, Celluloseether, Styrol/Maleinsäureanhydrid-Copolymeres oder ein Copolymeres oder Terpolymeres mit Einheiten von Methylmethacrylat und Methacrylsäure ist.

6. Photopolymerisierbares Gemisch nach Anspruch 1, dadurch gekennzeichnet, daß es als weiteren Photoinitiator Michlers Keton enthält.

7. Photopolymerisierbares Aufzeichnungsmaterial mit einem Schichtträger und einer photopolymerisierbaren Schicht, dadurch gekennzeichnet, daß die Schicht aus einem Gemisch gemäß einem der Ansprüche 1 bis 5 besteht.